# EUROPÄISCHE PATENTSCHRIFT

(11) **EP 2 884 828 B1**
(45) Veröffentlichungstag und Bekanntmachung des Hinweises auf die Patenterteilung: **07.09.2016**
(21) Anmeldenummer: 14193406.7
(22) Anmeldetag: 17.11.2014
(51) Int. Cl.: H05K 7/14

(54) **Elektrisches Gerät mit voneinander getrennten Gehäuseräumen**
Electrical device having separated housing areas
Appareil électrique ayant des espaces de boîtiers séparés l'un de l'autre

(30) Priorität: 16.12.2013 DE 102013226067
(43) Veröffentlichungstag der Anmeldung: 17.06.2015
(73) Patentinhaber: ROBERT BOSCH GMBH, 70442 Stuttgart (DE)
(72) Erfinder: Hennel, Udo, 74343 Sachsenheim (DE); Meincke, Georg, 71229 Leonberg (DE)

(56) Entgegenhaltungen:
- US-A1- 2003 067 748
- US-A1- 2012 020 023
- "Maxim > Design Support > Technical Documents > Tutorials > General Engineering Topics > APP 5250 Tin Whiskers Are Real and Complex By: John O'Boyle, Senior Business Manager, Military and Aerospace Business Unit", , 13. Dezember 2011 (2011-12-13), XP55210374, Gefunden im Internet: URL:http://pdfserv.maximintegrated.com/en/ an/TUT5250.pdf [gefunden am 2015-08-31]

## Beschreibung

### Stand der Technik

Die Erfindung betrifft ein elektrisches Gerät mit einem Gehäuse. Das Gerät weist wenigstens einen Hochstromschaltkreis auf, wobei der Hochstromschaltkreis wenigstens ein Leistungsbauelement und wenigstens einen Steuerschaltkreis umfasst.

Bei aus dem Stand der Technik bekannten Geräten, welche einen Steuerschaltkreis und einen Hochstromschaltkreis aufweisen, besteht das Problem, dass insbesondere bei einer elektrischen Verbindung von Leistungsbauelementen mittels Stromschienen, beim Verschrauben der Stromschienen mit einem elektrischen Anschluss der Leistungsbauelemente feine Metallsplitter, welche sich beim Verschrauben von Anschlüssen oder von den Schrauben lösen können, in den Steuerschaltkreis, insbesondere eine den Steuerschaltkreis bildende Elektronik gelangen können, wo die Metallsplitter Kurzschlüsse verursachen können.

Aus der US 2012/0020023 A1 ist eine Elektronikanordnung zur Verwendung in einem Fahrzeug bekannt, welche ein externes Gehäuse mit Außenwänden und einer Innenwand, die das externe Gehäuse in ein Elektronikfach und ein Fach ohne Elektronik unterteilt aufweist. Eine Wärme erzeugende Elektronikanordnung ist im Elektronikfach benachbart zu der Innenwand angeordnet. Eine Steuerelektronikanordnung ist im Elektronikfach benachbart zu der Wärme erzeugenden Elektronikanordnung angeordnet, wobei der Steuerelektronikabschnitt die Wärme erzeugende Elektronikanordnung steuert. Ein interner Wärmeschirm erstreckt sich zwischen der Steuerelektronikanordnung und der Wärme erzeugenden Elektronikanordnung und schirmt diese von jener ab, wobei der interne Wärmeschirm aus einem thermisch leitfähigen Material besteht und einen Kontaktabschnitt aufweist, der an der Innenwand angebracht ist, wodurch Wärme, die von dem internen Wärmeschirm absorbiert wird, an die Innenwand übertragen wird.

Aus der US 2003/067748 A1 ist ein Invertergehäuse, bekannt, das einen Hohlraum für ein Leistungsmodul aufweist, und eine Steuer-Leiterplatte umfasst, wobei die Steuer-Leiterplatte den Hohlraum in zwei Hohlraumteile auftrennt.

### Offenbarung der Erfindung

Erfindungsgemäß weist das Gehäuse der eingangs genannten Art einen Gehäuseraum für den Hochstromschaltkreis und einen Gehäuseraum für den Steuerschaltkreis auf. Das Gehäuse weist wenigstens eine Trennwand auf, welche ausgebildet und angeordnet ist, die Gehäuseräume jeweils voneinander zu trennen und einander abzudichten. Mittels des so ausgebildeten Gehäuses und mit der so ausgebildeten Gehäuseraumanordnung können vorteilhaft keine Metallmit der so ausgebildeten Gehäuseraumanordnung können vorteilhaft keine Metallsplitter oder Metallspäne, welche sich während eines Montageprozesses der Leistungsbauelemente des Hochstromschaltkreises von Teilen einer Beschichtung oder von Teilen, welche miteinander verschraubt, gesteckt oder geschweißt werden, von dem Hochstromschaltkreis in den Steuerschaltkreis gelangen und dort Kurzschlüsse oder elektrische Fehler verursachen. Weiter wurde erkannt, dass bei verzinnten Kontakten von Stromschienen, bei hohen mechanischen Spannungen im Bereich einer Verschraubung ein beschleunigtes Whisker-Wachstum auftreten kann. Während des Betriebs des elektrischen Gerätes können somit Whisker in Form von feinen Zinn-Haaren oder Zinn-Fäden entstehen, welche sich beispielsweise bei Vibrationen, insbesondere bei einem elektrischen Gerät für ein Kraftfahrzeug, lösen können und dann von dem Hochstromkontakt zu dem Steuerschaltkreis gelangen können und dort Kurzschlüsse oder elektrische Fehler verursachen können.

Bevorzugt weist der Steuerschaltkreis wenigstens eine Verarbeitungseinheit, insbesondere einen Mikrocontroller oder einen Mikroprozessor auf. Die Verarbeitungseinheit ist ausgebildet, Steuersignale zum Ansteuern des Hochstromschaltkreises zu erzeugen und an den Hochstromschaltkreis zu senden.

In einer bevorzugten Ausführungsform weist der Hochstromschaltkreis wenigstens zwei elektrische Leistungsbauelemente auf, welche mittels wenigstens einer Stromschiene miteinander elektrisch verbunden sind. Der Steuerschaltkreis weist bevorzugt wenigstens eine Verarbeitungseinheit auf, welche mit dem Hochstromschaltkreis, insbesondere mittels einer elektrischen Steuerleitung, elektrisch verbunden und ausgebildet ist, den Hochstromschaltkreis zu steuern. Bevorzugt sind elektrische Anschlüsse der wenigstens zwei Leistungsbauelemente mittels wenigstens einer Schraubverbindung mit der wenigstens einen Stromschiene verbunden. Der Hochstromschaltkreis ist bevorzugt ausgebildet, einen Strom mit einer Stromstärke von wenigstens 100 Ampere zu führen. Das Leistungsbauelement ist bevorzugt ausgebildet, den Strom mit wenigstens einer Stromstärke von wenigstens 50 Ampere, weiter bevorzugt wenigstens 100 Ampere, oder einem Strom zwischen 100 und 500 Ampere zu führen.

Beispielsweise ist wenigstens ein Leistungsbauelement durch einen Zwischenkreiskondensator und wenigstens ein weiteres Leistungsbauelement durch einen Inverter gebildet. Der Inverter ist bevorzugt ausgebildet, eine elektrische Maschine, insbesondere eine elektrische Maschine eines Elektrofahrzeugs zum Erzeugen eines magnetischen Drehfeldes zu bestromen. Die Verarbeitungseinheit ist bevorzugt ausgebildet, den Inverter zum Bestromen der elektronischen Maschine und zum Erzeugen des magnetischen Drehfeldes - bevorzugt mittels Pulsweitenmodulation - anzusteuern.

Die Trennwand kann bei dem so ausgebildeten elektrischen Gerät mit dem Hochstromschaltkreis umfassend wenigstens zwei Leistungsbauelemente, welche mittels einer Stromschiene miteinander schraubverbunden sind, den Steuerschaltkreis vor Metallspänen, insbesondere Flitter oder Whisker, welche beim Betrieb entstehen, absichern.

In einer bevorzugten Ausführungsform weist das Gerät wenigstens ein Kühlelement auf, welches mit wenigstens einem Leistungsbauelement des Geräts wärmeleitend verbunden und ausgebildet ist, von dem Leistungsbauelement erzeugte Verlustwärme abzuführen. Das Kühlelement ist beispielsweise durch einen Kühlblock, insbesondere einen Aluminiumblock, gebildet. Bevorzugt weist das Kühlelement wenigstens einen Fluidkanal auf, welcher ausgebildet ist, ein Kühlmedium, insbesondere eine Kühlflüssigkeit oder ein Kältemittel zu führen.

Mittels des Kühlelements kann das Leistungsbauelement vorteilhaft gekühlt werden. Die Trennwand bewirkt im Zusammenhang mit dem Kühlelement weiter vorteilhaft, dass im Falle von Kondensatbildung im Bereich des Kühlelements, keine Feuchtigkeit oder Kondensat in den Bereich des Steuerschaltkreises gelangen kann. Bevorzugt ist die Trennwand dazu ausgebildet, die Gehäuseräume feuchtigkeitsdicht, weiter bevorzugt wasserdampfdicht einander abzudichten.

Die Trennwand kann dazu beispielsweise mittels eines gegen Feuchtigkeit abdichtenden Klebstoffs, beispielsweise eines Silikonklebstoffs, im Bereich von Nahtstellen oder Fügestellen, mit einer das übrige Gehäuse bildenden Gehäusewand abgedichtet sein. Die Trennwand ist bevorzugt kabeldurchtrittsfrei ausgebildet. In einer anderen Ausführungsform weist die Trennwand Kabeldurchbrüche auf, welche bevorzugt mittels einer insbesondere elastisch ausgebildeten Dichtung, beispielsweise einer Silikongummi-Dichtung gegen den Durchbruch durchdringende Feuchtigkeit oder Fremdkörper, insbesondere die zuvor erwähnten Metallspäne, abgedichtet sind.

Bevorzugt weist das Gehäuse einen Gehäuseboden auf, wobei das Kühlelement im Bereich des Gehäusebodens angeordnet ist. Weiter bevorzugt bildet der Gehäuseboden eine Unterseite des Gehäuses. So kann vorteilhaft von dem Kühlelement herabgekühlte Umgebungsluft in dem Gehäuseraum für den Hochstromschaltkreis verbleiben, sodass weiter vorteilhaft keine Gefahr für eine Betauung des Steuerschaltkreises besteht.

Bevorzugt ist das Kühlelement mit dem Gehäuseboden wärmeleitend verbunden oder der Gehäuseboden ist durch das Kühlelement gebildet. So kann das Kühlelement vorteilhaft eine tiefste Position im Bereich des Gehäuseraumes einnehmen. So kann vorteilhaft die von dem Kühlelement gekühlte Luft, welche das Kühlelement umgibt, auch in dem Gehäuseraum für den Hochstromschaltkreis vorteilhaft im Bereich des Gehäusebodens verbleiben, insoweit die gekühlte Umgebungsluft schwerer ist als eine Luft in dem Gehäuseraum für den Hochstromschaltkreis, welcher wärmer ist als die gekühlte Luft im Bereich des Kühlelements.

In einer bevorzugten Ausführungsform erstreckt sich die Trennwand parallel zu dem Gehäuseboden. So ist der Gehäuseraum mit dem Steuerschaltkreis entlang einer Hochachse des Gehäuses zu dem Gehäuseraum mit dem Hochstromschaltkreis benachbart angeordnet, wobei die Hochachse quer zu dem Gehäuseboden verläuft. Mit dem so ausgebildeten Gehäuse, welches bevorzugt wenigstens teilweise als Gehäusebecher ausgebildet ist, kann vorteilhaft beim Verschrauben der Leistungsbauelemente mit der Stromschiene entstehende Metallspäne nicht in den Steuerschaltkreis gelangen, insoweit der Steuerschaltkreis entlang der Hochachse über dem Hochstromschaltkreis angeordnet ist. Der Steuerschaltkreis kann somit vorteilhaft nach einer Montage des Hochstromschaltkreises und nach einem Einfügen der Trennwand erfolgen, wobei die Trennwand den Hochstromschaltkreis von dem Steuerschaltkreis räumlich trennt. In einer bevorzugten Ausführungsform ist die Trennwand für Metallspäne wie für Whisker oder Flitter undurchlässig ausgebildet. Bevorzugt ist die Trennwand ausgebildet, die Gehäuseräume für Flitter oder Whisker mit einer Längsersteckung von wenigstens 0,2 Millimeter, oder einer Längserstreckung zwischen 0,2 Millimeter und 6 Millimeter einander abzudichten.

Weiter bevorzugt ist die Trennwand für kondensierte und/oder dampfförmige Feuchtigkeit undurchlässig ausgebildet. So können vorteilhaft weder Metallpartikel oder Kondensat von dem Hochstromschaltkreis in den Gehäuseraum gelangen, in welchem der Steuerschaltkreis angeordnet ist.

In einer bevorzugten Ausführungsform weist die Trennwand wenigstens auf einer Seite eine adhäsiv ausgebildete Schicht, insbsondere Klebstoffschicht auf, welche ausgebildet ist, Metallspäne, insbesondere nicht magnetisierbare Metallspäne, klebend festzuhalten. Der Klebstoff der Klebstoffschicht ist bevorzugt ein nichtaustrocknender Klebstoff, beispielsweise ein Leim, ein Harz oder ein Dispersionsklebstoff. Die Seite mit der Klebstoffschicht ist bevorzugt dem Gehäuseraum für den Hochstromschaltkreis zugewandt.

Mittels der so ausgebildeten Trennwand mit der Klebstoffschicht können vorteilhaft während des Betriebs des elektrischen Geräts entstehende Whisker, welche sich bei Vibrationen von dem elektrischen Anschluss oder der Stromschiene lösen können, an der Trennwand kleben bleiben und so nicht in dem Gehäuseraum für den Hochstromschaltkreis Kurzschlüsse verursachen und auch nicht in den Gehäuseraum für den Steuerschaltkreis gelangen. Weiter bevorzugt ist die Trennwand feuchtigkeits- und/oder wasserdampfundurchlässig ausgebildet. Weiter bevorzugt ist die Trennwand feuchtigkeits- und/oder wasserdampfabsorbierend ausgebildet. Dazu kann die Trennwand beispielsweise mittels Silicagel beschichtet sein oder wenigstens einen Vorratsbehälter aufweisen, in welchem Silicagel angeordnet ist. Mittels des Silicagels kann vorteilhaft Wasserdampf, welcher in den Gehäuseraum mit dem Hochstromschaltkreis hinein gelangt, absorbiert werden.

Die Erfindung betrifft auch ein Verfahren zum Erzeugen eines elektrischen Geräts mit einem Gehäuse,

### umfassend die insbesondere aufeinanderfolgenden Schritte:

- Einbringen eines Kühlelements durch eine Gehäuseöffnung des Gehäuses und Anordnen eines Kühlelements auf einem Gehäuseboden des Gehäuses und Verbinden des Kühlelements mit dem Gehäuse, wodurch vorteilhaft durch das Kühlelement gekühlte kalte Luft am Gehäuseboden verbleibt und so eine Wahrscheinlichkeit einer Kondensatabscheidung an darüberliegenden elektronischen Komponenten klein ist;
- wärmeleitendes Verbinden wenigstens eines Leistungsbauelements mit dem Kühlelement, wodurch eine Wärmeableitung weiter verbessert werden kann, und elektrisches Verbinden eines elektrischen Anschlusses des Leistungsbauelements mittels wenigstens einer Stromschiene insbesondere durch Verschrauben der Stromschiene mit dem Anschluss, wodurch Metallflitter in den Gehäuseraum freigesetzt werden können;
- Einbringen einer Trennwand in das Gehäuse, die einen Gehäuseraum in dem das Leistungsbauelement angeordnet ist, von einem Gehäuseraum für einen Steuer-Schaltkreis partikeldicht und/oder feuchtigkeitsdicht trennt, so dass der über dem Gehäuseraum mit den Leistungsbauelementen liegende Gehäuseraum durch die Trennwand getrennt ist, und so auch die Metallflitter nicht mehr in den benachbart angeordneten, insbesondere darüberliegenden Gehäuseraum für den Steuer-Schaltkreis gelangen können;
- Einbringen des Steuerschaltkreises in den Gehäuseraum für den Steuerschaltkreis, welcher so durch die Trennwand vor den Metallflittern sicher ist;
- Verschließen einer Gehäuseöffnung des Gehäuses mit einem Gehäusedeckel, so dass das Gehäuse vorteilhaft vor eindringender Feuchtigkeit und/oder Verschmutzung abgedichtet ist.

Die Erfindung wird nun im Folgenden anhand von Figuren und weiteren Ausführungsbeispielen beschrieben. Weitere vorteilhafte Ausführungsformen ergeben sich aus den in den Figuren und den abhängigen Ansprüchen beschriebenen Merkmalen.

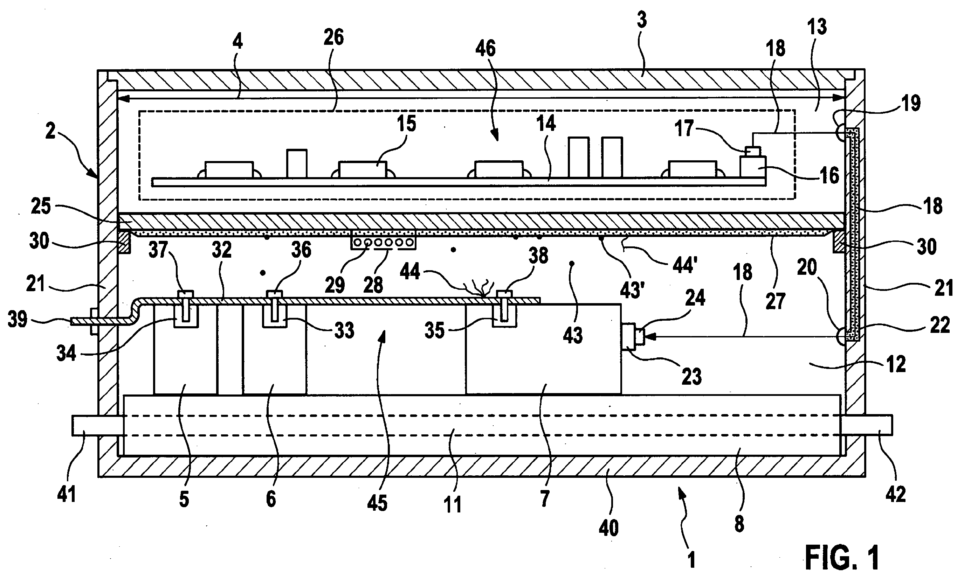

Figur 1 zeigt ein Ausführungsbeispiel für ein elektrisches Gerät, das eine Trennwand aufweist, welche ausgebildet und angeordnet ist, einen Gehäuseraum in zwei zueinander benachbarte Gehäuseräume, nämlich einen Gehäuseraum für einen Hochstromschaltkreis und einen Gehäuseraum für einen Steuer-Schaltkreis aufzuteilen.

Figur 1 zeigt ein Ausführungsbeispiel für ein elektrisches Gerät 1. Das elektrische Gerät 1 weist ein Gehäuse 2 auf. Das Gehäuse 2 ist in diesem Ausführungsbeispiel becher- oder wannenförmig ausgebildet. Das Gehäuse 2 weist einen Gehäusedeckel 3 auf, welcher ausgebildet ist, eine Gehäuseöffnung 4 des Gehäuses 2 zu verschließen.

Das elektrische Gerät 1 weist einen Hochstromschaltkreis 45 auf, wobei der Hochstromschaltkreis 45 in diesem Ausführungsbeispiel einen Zwischenkreiskondensator 5 und einen Zwischenkreiskondensator 6 und einen Inverter 7 aufweist. Die Zwischenkreiskondensatoren 5, 6 und der Inverter 7 bilden jeweils ein Leistungsbauelement. Der Zwischenkreiskondensator 5 weist einen elektrischen Schraubanschluss 34 auf, der Zwischenkreiskondensator 6 einen elektrischen Schraubanschluss 33 und der Inverter 7 einen elektrischen Schraubanschluss 35 auf. Die Schraubanschlüsse 33, 34 und 35 sind jeweils mittels einer Stromschiene 32 miteinander elektrisch schraubverbunden. Die Stromschiene 32 ist dazu mittels einer Schraube 37 mit dem Schraubanschluss 34, mittels einer Schraube 36 mit dem Schraubanschluss 33 und mittels einer Schraube 38 mit dem Schraubanschluss 35 verbunden. Die Stromschiene 32 ist durch eine Gehäusewand 21, insbesondere einen Durchbruch in der Gehäusewand 21, hindurchgeführt und mit einem elektrischen Anschluss 39 verbunden, mit welchem das elektrische Gerät 1 nach außen hin elektrisch verbunden werden kann. Der Hochstromschaltkreis, welcher in diesem Ausführungsbeispiel die Leistungsbauelemente wie die Zwischenkreiskondensatoren 5, 6 und den Inverter 7 aufweist, ist in diesem Ausführungsbeispiel zusammen mit einem Kühlelement 8 in einem Gehäuseraum 12 angeordnet.

Die Zwischenkreiskondensatoren 5, 6 und der Inverter 7 sind jeweils mit dem Kühlelement 8 wärmeleitend verbunden. Das Kühlelement 8 weist in diesem Ausführungsbeispiel einen Fluidkanal 11 zum Führen eines Kühlfluides auf.

Das Kühlelement 8 weist auch einen Fluidanschluss 41 und einen Fluidanschluss 42 auf, welche jeweils an das Kühlelement 8 angeformt sind. Die Fluidanschlüsse 41 und 42 sind jeweils mit dem Fluidkanal 11 wirkverbunden, sodass ein Fluid durch den Fluidanschluss 41 in das Kühlelement 8 und dort in den Fluidkanal 11 eingeleitet werden kann und zum Fluidanschluss 42 wieder aus dem Kühlelement 8 ausfließen kann.

Die Leistungsbauelemente, wie die Zwischenkreiskondensatoren 5, 6 und der Inverter 7, sind mit dem Kühlelement 8 wärmeleitend verbunden. Die Leistungsbauelemente 5, 6 und der Inverter 7 sind gemeinsam mit dem Kühlelement 8 in einem Gehäuseraum 12 angeordnet. Der Gehäuseraum 12 schließt an einen Boden 40 des Gehäuses 2 an.

Der Inverter 7 weist in diesem Ausführungsbeispiel einen elektrischen Anschluss 23 auf, welcher mit einer Verbindungsleitung 18, insbesondere einem mit der Verbindungsleitung 18 verbundenen Stecker 24, elektrisch verbunden ist.

Der elektrische Anschluss 23 bildet dabei einen Steueranschluss für den Inverter 7, insbesondere für Steueranschlüsse von Leistungs-Halbleiterschaltern des Inverters 7, insbesondere Halbleiterschalter-Halbbrücken mit Leistungstransistoren als Halbleiterschalter, insbesondere Feldeffekttransistoren oder IGBT-Transistoren (IGBT = Insulated-Gate-Bipolar-Transistor).

Die Verbindungsleitung 18 ist über eine Ausnehmung oder einen Hohlraum 22 in der Gehäuserwand 21 des Gehäuses 2 bis hin zu einem weiteren Gehäuseraum 13 des Gehäuses 2 geführt.

Der Gehäuseraum 13 ist im Bereich der Verbindungsleitung 18 mittels einer elastisch ausgebildeten Dichtung 19 gegen die Ausnehmung 22 abgedichtet. Der Gehäuseraum 12 ist im Bereich der Verbindungsleitung 18 mittels einer elastisch ausgebildeten Dichtung 20 zu der Ausnehmung 22 hin abgedichtet. Die Ausnehmung 22 ist beispielsweise durch einen sich längserstreckenden Kanal oder eine Röhre gebildet.

Das elektrische Gerät 1 weist auch eine Trennwand 25 auf. Die Trennwand 25 ist in diesem Ausführungsbeispiel ausgebildet und angeordnet, die Gehäuseräume 12 und 13 voneinander zu trennen und einander abzudichten. Die Trennwand 25 liegt mit einem Trennwandrand der Trennwand 25 auf einem Vorsprung 30 auf, welcher in diesem Ausführungsbeispiel umlaufend ausgebildet ist. Die Trennwand 25 ist beispielsweise aus Kunststoff oder aus Blech gebildet.

Das elektrische Gerät 1 weist auch einen Steuerschaltkreis 46 auf, welcher eine Leiterplatte 14 und elektronische Bauelemente umfasst. Von den elektronischen Bauelementen ist ein Mikroprozessor 15 beispielhaft bezeichnet, welcher eine zuvor genannte Verarbeitungseinheit bildet. Der Steuerschaltkreis 46, insbesondere die Leiterplatte 14 des Steuerschaltkreises 46, weist einen elektrischen Anschluss 16 auf, welcher über einen Stecker 17 mit der Verbindungsleitung 18 verbunden ist. Der Steuerschaltkreis kann so Steuersignale zum Ansteuern des Inverters 7 erzeugen und über die Verbindungsleitung 18 an den Inverter 7, insbesondere den Anschluss 23 des Inverters 7, senden.

Die Trennwand 25 weist in diesem Ausführungsbeispiel eine insbesondere permanent klebrig ausgebildete Klebstoffbeschichtung 27 auf, welche dem Gehäuseraum 12 zugewandt ist.

Wenn beispielsweise bei einer Montage des elektrischen Gerätes 1 der Gehäusedeckel 3 geöffnet ist, kann das Kühlelement 8 zuerst in das Gehäuse 2 eingefügt werden und mit dem Boden 40 wärmeleitend verbunden werden. So kann über den Boden 40 zusätzlich zu der Fluidleitung 11 Wärme über den Boden 40 abgeführt werden. In einem weiteren Fertigungsschritt können dann die Leistungsbauelemente wie die Zwischenkreiskondensatoren 5, 6 und der Inverter 7 mit dem Kühlelement 8 wärmeleitend verbunden werden, beispielsweise mittels eines wärmeleitfähigen Klebstoffs. Die Verbindungsleitung 18 kann dann beispielsweise mittels des Steckers 24 mit dem Anschluss 23 des Inverters 7 verbunden werden und in die Ausnehmung 22 in der Wand 21 eingelegt werden. Die Verbindungsleitung 18 kann dann beispielsweise mittels einer elastisch ausgebildeten Dichtmasse, beispielsweise einer Silikon-Dichtmasse, in der Ausnehmung 22 eingespritzt werden.

Die Leistungsbauelemente wie die Zwischenkreiskondensatoren 5, 6 und der Inverter 7 können dann mittels einer Stromschiene 32, beispielsweise einer Kupferblech-Schiene, miteinander elektrisch verbunden werden. Dazu wird die Stromschiene 32 mittels der Schrauben 36, 37 und 38 mit den jeweiligen Anschlüssen 33, 34 und 35 der Leistungsbauelemente verschraubt. Die Stromschiene 32 wird dabei zu einem äußeren Anschluss 39 durch den äußeren Rand 21 hindurchgeführt und dabei abgedichtet.

Beim Festziehen der Schrauben 36, 37 und 38 können beispielsweise Metallspäne, insbesondere Metallflitter, abgehen, von denen der Metallflitter 43 beispielhaft bezeichnet ist.

In einem anschließenden Fertigungsschritt wird die Trennwand 25, mit der klebrig ausgebildeten Schicht 27 zu den Leistungsbauelementen 5, 6 und 7 gewandt, durch die Gehäuseöffnung 4 eingeführt und auf den umlaufenden Vorsprung 30 aufgesetzt.

Vorteilhaft kann die Trennwand 25 mittels der Klebstoffschicht 27 mit dem Vorsprung 30 dicht verklebt werden, so dass der Klebstoff sowohl eine Dicht- und Klebewirkung, als auch eine Haftwirkung für die Metallspäne aufweist.

Der Gehäuseraum 12 ist dann bereits gegen den Gehäuseraum 13 abgedichtet. Der Metallflitter 43 kann dann beispielsweise in Folge von Erschütterungen sich in dem Gehäuseraum 12 bewegen und an der klebrig ausgebildeten Klebeschicht 27 als festgeklebter Metallflitter 43' kleben bleiben.

Während eines Betriebs des elektrischen Geräts 1 können beispielsweise im Bereich eines elektrischen Anschlusses, beispielsweise des elektrischen Anschlusses 35 des Inverters 7, Metall-Whisker 44 an der Stromschiene 32 ausgebildet werden. Der Metall-Whisker 44 kann sich beispielsweise durch Vibrationen lösen und kann dann von der klebrig ausgebildeten Klebstoffschicht 27 als festgeklebter Metall-Whisker 44' festgehalten werden.

Die Leiterplatte 14, welche den zuvor erwähnten Steuerschaltkreis ausbildet, kann dann in einem weiteren Schritt durch die Gehäuseöffnung 4 in den Gehäuseraum 13 eingebracht werden und der Anschluss 16 mit der Verbindungsleitung 18 über den Stecker 17 steckverbunden werden.

Anschließend kann das Gehäuse 2 mittels des Gehäusedeckels 3 verschlossen werden.

Zusätzlich oder unabhängig von der Klebstoffschicht 27 kann die Trennwand 25 ein feuchtigkeitsabsorbierend ausgebildetes Trockenmittel 29 aufweisen. Das Trockenmittel 29 ist beispielsweise durch Silica-Gel gebildet. Das Trockenmittel 29 ist in diesem Ausführungsbeispiel in einem mit der Trennwand 25 verbundenen, insbesondere klebverbundenen, Behälter 28 angeordnet.

Die Leiterplatte 14 kann beispielsweise in einer anderen Ausführungsform gemeinsam mit den elektronischen Bauelementen wie dem Mikroprozessor 15, in einer geschlossenen Box 26 aufgenommen sein. Die geschlossene Box 26 kann somit vorteilhaft eine zusätzliche Schutzkapsel für die Leiterplatte 14 bilden. Die Box 26 ist beispielsweise durch eine Kunststoffbox gebildet. Die Box 26 ist in diesem Ausführungsbeispiel feuchtigkeitsdicht und partikeldicht ausgebildet. Die Verbindungsleitung 18 kann beispielsweise durch einen Durchbruch in der Box 26 zu der Ausnehmung 22 geführt sein, wobei die Verbindungsleitung 18 beispielsweise mittels eines spritzfähigen Dichtmittels, insbesondere Silikonklebstoff, gegen eine Wand der Box 26 abgedichtet ist.

## Patentansprüche

1. Elektrisches Gerät (1) mit einem Gehäuse (2), wobei das Gerät (1) wenigstens einen Hochstrom-Schaltkreis (45) umfassend wenigstens ein Leistungsbauelement und wenigstens einen Steuer-Schaltkreis (46) aufweist,
**dadurch gekennzeichnet, dass**
das Gehäuse (2) für den Hochstromschaltkreis (45) einen Gehäuseraum (12) und für den Steuer-Schaltkreis (46) einen Gehäuseraum (13) aufweist, und das Gehäuse (2) wenigstens eine Trennwand (25) aufweist, welche ausgebildet und angeordnet ist, die Gehäuseräume (12, 13) jeweils voneinander zu trennen und einander abzudichten,
wobei die Trennwand (25) wenigstens auf einer Seite eine adhäsiv ausgebildete Schicht (27) aufweist, welche ausgebildet ist, Metallspäne (43, 44) klebend festzuhalten.

2. Gerät (1) nach Anspruch 1,
**dadurch gekennzeichnet, dass**
die Schicht (27) ausgebildet ist, nichtmagnetisierbare Metallspäne klebend festzuhalten.

3. Gerät (1) nach Anspruch 1 oder 2,
**dadurch gekennzeichnet, dass**
die Schicht (27) eine Klebstoffschicht ist, wobei der Klebstoff der Klebstoffschicht ein nichtaustrocknender Klebstoff ist.

4. Gerät nach Anspruch 3,
**dadurch gekennzeichnet, dass**
der Klebstoff ein Leim, ein Harz oder ein Dispersionsklebstoff ist.

5. Gerät nach einem der vorhergehenden Ansprüche 3 oder 4,
wobei die Seite der Trennwand (25) mit der Klebstoffschicht dem Gehäuseraum (12) für den Hochstromschaltkreis zugewandt ist.

6. Gerät (1) nach Anspruch 1,
**dadurch gekennzeichnet, dass**
bei dem Hochstrom-Schaltkreis (45) wenigstens zwei elektrische Leistungsbauelemente (5, 6, 7) mittels wenigstens einer Stromschiene (32) miteinander elektrisch verbunden sind, und der Steuer-Schaltkreis (46) wenigstens eine Verarbeitungseinheit (15) aufweist, welche mit dem Hochstrom-Schaltkreis (45) verbunden und ausgebildet ist, den Hochstrom-Schaltkreis (45) zu steuern.

7. Gerät (1) nach einem der vorhergehenden Ansprüche, wobei das Gerät (1) wenigstens ein Kühlelement (8) aufweist, welches mit wenigstens einem Leistungsbauelement (5, 6, 7) des Geräts (1) wärmeleitend verbunden und ausgebildet ist, von dem Leistungsbauelement (5, 6, 7) erzeugte Verlustwärme abzuführen.

8. Gerät (1) nach einem der vorhergehenden Ansprüche,
**dadurch gekennzeichnet, dass**
das Gehäuse (2) einen Gehäuseboden (40) aufweist, und das Kühlelement (8) im Bereich des Gehäusebodens (40) angeordnet ist.

9. Gerät (1) nach Anspruch 8,
**dadurch gekennzeichnet, dass**
das Kühlelement (8) mit dem Gehäuseboden (40) wärmeleitend verbunden ist oder der Gehäuseboden (40) durch das Kühlelement (8) gebildet ist.

10. Gerät (1) nach einem der vorhergehenden Ansprüche 8 oder 9, **dadurch gekennzeichnet, dass**
die Trennwand parallel zu dem Gehäuseboden verläuft.

11. Gerät (1) nach einem der vorhergehenden Ansprüche,
**dadurch gekennzeichnet, dass**
die Trennwand (25) für Metallspäne (43, 44) wie Whisker (44) oder Flitter (43) undurchlässig ausgebildet ist.

12. Gerät (1) nach einem der vorhergehenden Ansprüche,
**dadurch gekennzeichnet, dass**
die Trennwand (25) feuchtigkeits- und/oder wasserdampfundurchlässig ausgebildet ist.

## Claims

1. Electrical device (1) having a housing (2), wherein the device (1) has at least one high-current circuit (45) comprising at least one power component and at least one control circuit (46),
**characterized in that**
the housing (2) has a housing area (12) for the high-current circuit (45) and a housing area (13) for the control circuit (46), and the housing (2) has at least one separating wall (25) which is designed and arranged to separate the housing areas (12, 13) from one another and to seal off the said housing areas from one another,
wherein the separating wall (25) has an adhesive layer (27) at least on one side, the said adhesive layer being designed to retain metal chips (43, 44) in an adhesive manner.

2. Device (1) according to Claim 1,
**characterized in that**
the layer (27) is designed to retain non-magnetizable metal chips in an adhesive manner.

3. Device (1) according to Claim 1 or 2,
**characterized in that**
the layer (27) is an adhesive layer, wherein the adhesive of the adhesive layer is a non-drying adhesive.

4. Device according to Claim 3,
**characterized in that**
the adhesive is a glue, a resin or a dispersion adhesive.

5. Device according to either of the preceding Claims 3 and 4,
wherein the side of the separating wall (25) with the adhesive layer faces the housing area (12) for the high-current circuit.

6. Device (1) according to Claim 1,
**characterized in that**,
in the high-current circuit (45), at least two electrical power components (5, 6, 7) are electrically connected to one another by means of at least one busbar (32), and the control circuit (46) has at least one processing unit (15) which is connected to the high-current circuit (45) and is designed to control the high-current circuit (45).

7. Device (1) according to one of the preceding claims,
wherein the device (1) has at least one cooling element (8) which is thermally conductively connected to at least one power component (5, 6, 7) of the device (1) and is designed to dissipate lost heat which is generated by the power component (5, 6, 7).

8. Device (1) according to one of the preceding claims,
**characterized in that**
the housing (2) has a housing base (40), and the cooling element (8) is arranged in the region of the housing base (40).

9. Device (1) according to Claim 8,
**characterized in that**
the cooling element (8) is thermally conductively connected to the housing base (40), or the housing base (40) is formed by the cooling element (8).

10. Device (1) according to either of the preceding Claims 8 and 9,
**characterized in that**
the separating wall runs parallel to the housing base.

11. Device (1) according to one of the preceding claims,
**characterized in that**
the separating wall (25) is designed to be impermeable to metal chips (43, 44), such as whiskers (44) or flakes (43).

12. Device (1) according to one of the preceding claims,
**characterized in that**
the separating wall (25) is designed to be impermeable to moisture and/or water vapour.

## Revendications

1. Appareil électrique (1) muni d'un boîtier (2), l'appareil (1) possédant au moins un circuit à courant fort (45) comprenant au moins un composant de puissance et au moins un circuit de commande (46),
**caractérisé en ce que**
le boîtier (2) possède un espace de boîtier (12) pour le circuit à courant fort (45) et un espace de boîtier (13) pour le circuit de commande (46), et le boîtier (2) possède au moins une paroi de séparation (25) qui est configurée et disposée pour séparer respectivement les espaces de boîtier (12, 13) l'un de l'autre et pour les rendre étanches l'un par rapport à l'autre,
la paroi de séparation (25) possédant au moins sur un côté une couche (27) réalisée adhésive qui est configurée pour retenir par adhérence les copeaux de métal (43, 44).

2. Appareil (1) selon la revendication 1, **caractérisé en ce que** la couche (27) est configurée pour retenir par adhérence les copeaux de métal non magnétisables.

3. Appareil (1) selon la revendication 1 ou 2, **caractérisé en ce que** la couche (27) est une couche d'adhésif, l'adhésif de la couche d'adhésif étant un adhésif qui ne dessèche pas.

4. Appareil selon la revendication 3, **caractérisé en ce que** l'adhésif est une colle, une résine ou un adhésif à dispersion.

5. Appareil selon l'une des revendications précédentes 3 ou 4, le coté de la paroi de séparation (25) muni de la couche d'adhésif faisant face à l'espace de boîtier (12) pour le circuit à courant fort.

6. Appareil (1) selon la revendication 1, **caractérisé en ce que** dans le circuit à courant fort (45), au moins deux composants de puissance (5, 6, 7) sont reliés électriquement entre eux au moyen d'au moins une barre-bus (32), et le circuit de commande (46) possède au moins une unité de traitement (15) qui est reliée au circuit à courant fort (45) et configurée pour commander le circuit à courant fort (45).

7. Appareil (1) selon l'une des revendications précédentes, l'appareil (1) possédant au moins un élément de refroidissement (8) qui est en liaison thermoconductrice avec au moins un composant de puissance (5, 6, 7) de l'appareil (1) et qui est configuré pour évacuer la chaleur dissipée produite par le composant de puissance (5, 6, 7).

8. Appareil (1) selon l'une des revendications précédentes, **caractérisé en ce que** le boîtier (2) possède un fond de boîtier (40) et l'élément de refroidissement (8) est disposé dans la zone du fond de boîtier (40).

9. Appareil (1) selon la revendication 8, **caractérisé en ce que** l'élément de refroidissement (8) est en liaison thermoconductrice avec le fond de boîtier (40) ou le fond de boîtier (40) est formé par l'élément de refroidissement (8).

10. Appareil (1) selon l'une des revendications précédentes 8 ou 9, **caractérisé en ce que** la paroi de séparation s'étend parallèlement au fond de boîtier.

11. Appareil (1) selon l'une des revendications précédentes, **caractérisé en ce que** la paroi de séparation (25) est configurée imperméable aux copeaux de métal (43, 44) tels que les barbes (44) ou les clinquants (43).

12. Appareil (1) selon l'une des revendications précédentes, **caractérisé en ce que** la paroi de séparation (25) est configurée imperméable à l'humidité et/ou à la vapeur d'eau.
